# EUROPEAN PATENT APPLICATION

(11) **EP 4 354 728 A1**
(43) Date of publication of application: **17.04.2024**
(21) Application number: 23202565.0
(22) Date of filing: 10.10.2023
(51) Int. Cl.: H03F 1/56, H03F 3/181, H03F 3/45

(54) **PREAMPLIFIER FOR CAPACITATOR MICROPHONE OPERATING IN THE INFRASONIC FREQUENCY RANGE**

(30) Priority: 14.10.2022 PL 44253222
(71) Applicant: Centrum Astronomiczne im. Mikolaja Kopernika Polskiej Akademii Nauk, 00-716 Warszawa (PL)
(72) Inventor: SUCHENEK, Mariusz, 05-230 Kobylka (PL)
(74) Representative: Wlasienko, Jozef

(57) **Abstract**

The subject matter of the invention relates to a preamplifier for a condenser microphone operating in the infrasound frequency range, comprising an operational amplifier (4), a condenser microphone (3), which is formed by a capacitor and a polarization voltage source (6).

The preamplifier for a condenser microphone is further provided with a polarization circuit (16) or a polarization resistor (1), wherein the polarization circuit (16) or the polarization resistor (1) is connected to the input of the operational amplifier (4) and to one end of the condenser microphone (3), whereas the other end of the condenser microphone (3) is connected to the polarization voltage source (6).

## Description

### FIELD OF THE INVENTION

The subject matter of the invention relates to a preamplifier for a condenser microphone operating in the infrasound frequency range and requiring the external polarization voltage.
According to the invention, the present solution relates to the field of electroacoustics, which combines elements of acoustics and electronics. The invention concerns particular, preamplifiers for a condenser microphone operating in the infrasound range.

### BACKGROUND OF THE INVENTION

Preamplifiers for condenser microphones are designed to transfer the electrical signal from a voltage polarized condenser microphone without distortions. Subsequent amplification stages most frequently carry out amplification of an electrical signal.

Essentially, a condenser microphone is a device designed to convert an acoustic signal into a change in capacitance. The popularity of condenser microphones is primarily related to their high sensitivity. Condenser microphones consist of a capsule formed by a thin electrically conductive diaphragm and a metal backplate electrically separated from it. The diaphragm and the metal backplate form an air capacitor, which is sensitive to vibrations by the movement of the diaphragm. When acoustic waves hit the diaphragm, it begins to vibrate, which causes a change in the distance between the movable diaphragm and the immovable metal backplate, thus changing the capacitance of the capacitor. The diaphragm forming the capacitor plate is charged with an electrical charge by a polarization resistor from the polarization voltage, the movement of the diaphragm causes a change in the voltage on the immovable metal backplate connected to an amplifier.

The preamplifier for a condenser microphone developed according to the invention is basically designed to make it possible to adapt the capacitance of a condenser microphone to the amplifier in such a way that it does not degrade the sensitivity of the microphone, in particular in the infrasound frequency range, and at the same time, it transfers the electrical signal from the condenser microphone without distortion.

Currently, there is no precise definition of the infrasound range; it is quite often assumed to be the frequency range of about 1 Hz to 20 Hz. It is becoming increasingly common to use the term of low-frequency noise covering the frequency range of even less than 1 Hz, which is far below the human hearing threshold. At the same time, many phenomena generate infrasound, such as earthquakes, atmospheric phenomena, sea waves, etc. In industry and infrastructure, e.g. wind turbines, trucks.

### DESCRIPTION OF THE PRIOR ART

In the prior art, there are available many preamplifiers for condenser microphones. Two types of condenser microphones are commonly used: condenser microphones that require external voltage polarization and condenser microphones that are initially polarized. The subject matter of the invention relates to a preamplifier for a condenser microphone operating in the infrasound range and requiring the external polarization voltage.

In the prior art, there is known Polish patent application no. P.374069 titled *"Preamplifier for the condenser microphone*", which discloses a preamplifier for condenser microphones, which is used especially for measuring acoustic signals, wherein a resistor connecting the end of a condenser microphone and a DC voltage source is connected in series to a key. The point connecting the series branch of the resistor and the key with the end of the condenser microphone is connected to a high input impedance amplifier through a coupling capacitor, and the input of the amplifier is connected to a second DC voltage source through a series connection consisting of a second key and a second resistor. The key is switched on from time to time in order to recharge the capacitor that forms the condenser microphone and maintain a constant charge level of the capacitor.

Furthermore, in the prior art, an American patent document No. US 7,620,189 B2 titled *"Polarization voltage setting of microphones"* is known, which discloses the setting of the polarization voltage of microphones. A microphone includes a microphone capsule powered with a polarization voltage from a winding on a transformer. The polarization voltage is controlled by a regulation circuit that may have an analogue regulation circuit and a digital regulation circuit. A controller adjusts the polarization voltage that varies the sensitivity of the microphone.

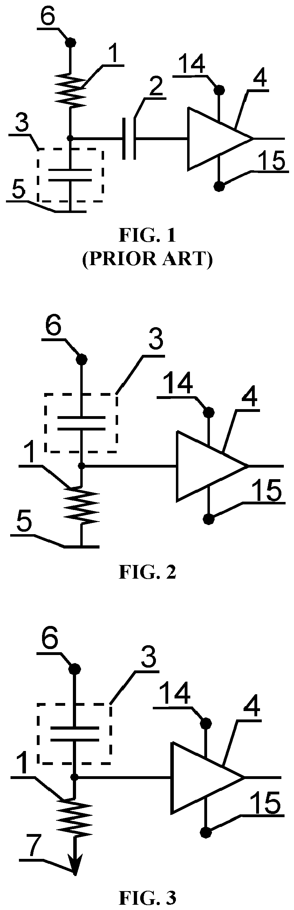

In the prior art, there are also known other patent documents, including the European patent document EP 3 454 568 B1 titled *"Microphone pre-amplifier with polarization voltage supply",* American patent document US 8,582,787 B2 titled *"Preamplifier circuit for a microelectromechanical capacitive acoustic transducer",* and another American patent document US 8,295,512 B2 titled *"Microphone with voltage pump",* which basically present the electronic structures of preamplifiers designed to receive electrical signals from a condenser microphone; their simplified electrical diagram has been illustrated in **FIG. 1** attached herewith. The presented electrical diagram illustrates a condenser microphone 3, a separating capacitor 2, a resistor 1, an operational amplifier 4, a polarization voltage source 6, a supply ground 5, a lower supply voltage 15 of the operational amplifier 4, an upper supply voltage 14 of the operational amplifier 4.

The resistor 1 and the polarization voltage source 6 form a voltage polarization circuit of the condenser microphone 3. The operational band of such a circuit is defined by the electronic elements 1, 2, 3 and depends on the parameters of the operational amplifier 4. The separating capacitor 2 in these solutions cuts off the constant component, which is the polarization voltage of the condenser microphone 3, typically is the voltage of 200 V and it is outside the operating range of a typical operational amplifier 4 or another circuit used to increase the electrical signal.

For the preamplifier operating in the infrasound frequency range according to the electrical diagram shown in FIG. 1, the operating range also includes the amplitudes for frequencies attenuated by the circuit formed by the electronic components: the separating capacitor 2, the condenser microphone 3, the resistor 1. This circuit always cuts off the constant component through the separating capacitor 2 and attenuates amplitudes for frequencies below the limit frequency resulting from the values of the elements of which the input circuit consists, which results from the structure and is a limitation of such a solution.

The above described prior-art solutions and more broadly solutions relating to preamplifiers for condenser microphones introduce a disadvantageous phenomenon of band limitation connected with the use of additional elements apart from the microphone and the amplifier, which is not insignificant when measuring acoustic signals, especially for low frequencies, which in turn limits the sensitivity of such preamplifiers in the infrasound range.

Therefore, the prior art does not provide a complementary preamplifier for a condenser microphone operating in the infrasound range, which would ensure appropriate sensitivity in the infrasound frequency range.

### SUMMARY OF THE INVENTION

The object of the invention is to develop a totally novel solution in the form of a preamplifier for a condenser microphone operating in the infrasound frequency range and requiring external polarization voltage, which consequently is to ensure transfer of the condenser microphone sensitivity, in particular in the infrasound frequency range, which preamplifier would accordingly transfer the signal from the condenser microphone without distortions.

The purpose of the developed solution in the form of a preamplifier is to adapt the amplifier and its input circuits to the capacitance of the condenser microphone in such a way that the amplifier does not worsen the microphone sensitivity, in particular in the infrasound frequency range, and at the same time it transfers the electrical signal of the condenser microphone without distortions.

In order to achieve the above purposes, according to one aspect of the invention, the invention provides a preamplifier for a condenser microphone operating in the infrasound frequency range, comprising an operational amplifier, a condenser microphone, which forms a capacitor, and a polarization voltage source, characterized in that it has a polarization circuit or a polarization resistor, wherein the polarization circuit or the polarization resistor is connected to the input of the operational amplifier and to one end of the condenser microphone, wherein the second end of the condenser microphone is connected to the polarization voltage source.

Preferably, the said polarization circuit consists of a first resistor, a second resistor and a third resistor, and a capacitor compensating for the capacitance of the condenser microphone, wherein one end of the capacitor is connected to the condenser microphone, to the inverting input of the operational amplifier and to the third resistor, whereas the other end thereof is connected to the output of the operational amplifier and to the first resistor, wherein, between the other end of the first resistor, it is connected the other end of the third resistor, and the second resistor which in turn is connected to the other voltage source, which can also be a ground, the other end of the condenser microphone is connected to the polarization voltage source the microphone, the non-inverting input of the operational amplifier is connected to the voltage source.

Preferably, the said polarization resistor is connected to a voltage in the range of the input voltages of the operational amplifier, which is between the supply voltage of the operational amplifier and the voltages of the fifth voltage source and the fourth voltage source.

Preferably, the said second end of the polarization resistor is connected to a supply ground or the first voltage source.

Preferably, the said non-inverting input of the operational amplifier is connected to the third voltage source which is between the supply voltage of the operational amplifier and the voltages of the fifth and the fourth voltage sources.

The solution provided according to the aspects proposed above provides a suitably adapted amplifier to a condenser microphone, which ensures a high sensitivity in the infrasound frequency range. The resultant sensitivity of the set of a condenser microphone connected to an amplifier depends on both the parameters of the condenser microphone and the amplifier itself with the usage of the designed elements and circuits according to the invention.

One indisputable advantage of the claimed solution is that there is no need to use a polarization resistor 1 the condenser microphone 3 having a high resistance. The lower frequency depends largely on the parameters of the amplifier 4 used. Another advantage of the proposed solution is that there is no need to use a separating capacitor 2 which separates a high voltage from the polarization voltage source 6 the condenser microphone 3 from the operational amplifier 4 used.

### BRIEF DESCRIPTION OF THE DRAWINGS

The subject matter of the invention is presented in the embodiment with reference to the attached drawings:
- **FIG. 1**: shows an electrical diagram of the preamplifier for a condenser microphone from the prior art;
- **FIG. 2**: shows an electrical diagram of the preamplifier for a condenser microphone according to the first embodiment of the invention;
- **FIG. 3**: shows an electrical diagram of the preamplifier for a condenser microphone according to the second embodiment of the invention;
- **FIG. 4**: shows an electrical diagram of the preamplifier for a condenser microphone according to the third embodiment of the invention.

### DETAILED DESCRIPTION OF THE INVENTION

The subject matter of the invention is described in detail below with reference to the attached figures and embodiments. The invention is not limited only to the detailed embodiments described herein.

The embodiment presented in **FIG. 2** and **FIG. 3** illustrates the electrical diagram of the preamplifier for a condenser microphone according to the first and second embodiment of the invention, respectively, wherein the structure of the preamplifier, as compared to the state of art illustrated in FIG. 1, has made it possible to eliminate a separating capacitor 2, including resignation from an external polarization circuit of the condenser microphone 3, and transfer its function to the polarization circuit of the preamplifier.

In the solution illustrated in **FIG. 2** and **FIG. 3****,** the preamplifier for a condenser microphone operating in the infrasound frequency range is equipped with a polarization resistor 1 whose one output is connected to a supply ground 5 in the first embodiment illustrated in **FIG. 2** or to the first voltage source 7 in the second embodiment illustrated in **FIG. 3****.** Importantly, the first voltage source 7 of the operational amplifier 4 is in the supply voltage range of between the supply voltage of the operational amplifier 4 and the voltages of the fifth voltage source 15 and the fourth voltage source 14. This solution eliminates the separating capacitor 2 the high voltage polarizing the condenser microphone 3 from the input of the operational amplifier 4. On the other hand, the second output of the polarization resistor 1, in both the first and second embodiment, is connected through the condenser microphone 3 to the source of the polarization voltage source 6. In the embodiment illustrated in **FIG. 2** and **FIG. 3****,** the input of the operational amplifier 4 is connected between the polarization resistor 1 and the condenser microphone 3.

A significant problem to be solved in relation to the prior art was the high value of the polarization resistor 1, which is designed to polarize the condenser microphone 3. With a typical microphone capacitance value on the order of 20 pF and cutoff frequency of about 0.1 Hz, the polarization resistor 1 should achieve a value of the order of 82 GS2 taking into account the input parameters of the operational amplifier 4 and the mounting of the components e.g. on a PCB or another mounting method. Mounting elements of an order of 100 GS2 is quite cumbersome as it is necessary to take into account also the parameters of laminate and to use special circuits protecting against current leakage on PCB.

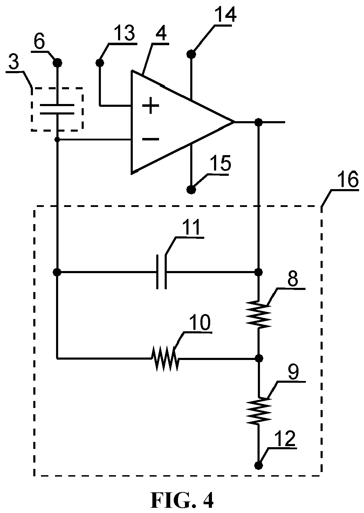

The solution according to the invention, when carrying out the preamplifier together with the operational amplifier 4, consists in using the polarization function of the circuit forming the preamplifier from the operational amplifier 4 also to polarize the capacitor forming the condenser microphone 3, as shown in the third embodiment in **FIG. 4****.** This solution makes it possible to construct the polarization circuit 16 of the condenser microphone 3 by using a circuit determining the operating mode of the operational amplifier 4, which allows one to resign from the external polarization circuit and the polarization resistor 1 of the condenser microphone 3. The cutoff frequency depends mainly on the polarization resistor 1, the capacitance of the microphone 3 and the input parameters of the operational amplifier 4.

In the third embodiment illustrated in **FIG. 4****,** instead of the polarization resistor 1 as illustrated in the above described first and second embodiment according to the invention, the polarization circuit 16 of the condenser microphone 3 and the operational amplifier 4 has been used, which has a double function, namely, it is to polarize the input of the operational amplifier 4 and to polarize the condenser microphone 3. The circuit of the operational amplifier 4 is used to ensure the polarization of the condenser microphone 3 as well, which was not possible in the configuration of **FIG. 1** through the separating capacitor 2 and a high voltage at the input of the operational amplifier 4.

The polarization circuit 16 consists of a first resistor 8, a second resistor 9 and a third resistor 10, and a capacitor 11 that compensates for the capacity of the condenser microphone 3, wherein one end of the capacitor 11 is connected to the condenser microphone 3, the input of the operational amplifier 4 and the resistor 10, whereas the other end thereof is connected to the output of the operational amplifier 4 and to the first resistor 8, and wherein, between the first resistor 8 and the third resistor 10, there is connected the second resistor 9 which in turn is connected to the second voltage source12.

In the embodiment presented, the operational amplifier 4 is powered from two voltage sources 15 and 14 and from an additional voltage source 13 non-inverting input of the operational amplifier 4. The voltage of the voltage source 13 should fall between the voltages of the voltage sources 15 and 14 of the operational amplifier 4.

The solution according to the invention developed in accordance with the embodiments presented makes it possible to resign from the separating capacitor 2 illustrated in the prior art of **FIG. 1****;** such the exemplary solutions are provided in **FIG. 2** and **FIG. 3****.** Additionally, it makes it possible to resign from the polarization resistor 1, as shown in the embodiment in **FIG. 4****.** Such the solution allows one to measure amplitudes at lower frequencies, which was not possible with a typical structure of an electrical signal preamplifier with a condenser microphone and with the use of elements comparable in terms of values, as presented in the prior-art electrical diagram in **FIG. 1****.**

The above description of presented embodiments has been provided in order to enable any person skilled in the art to carry out or use the invention. Various modifications of the embodiments presented are also possible, comprising all such changes, modifications and variants that fall within essence and scope of the appended claims. The basic principles set out herein may therefore be applied in other embodiments without going beyond the scope of the invention. Thus, the invention is not intended to be limited to the embodiments presented herein but to accord with the widest scope consistent with the principles and novel features set out herein.

The solution according to the invention thus offers, with the use of the above mentioned technical means indicated in **FIG. 4****,** a preamplifier for a condenser microphone operating in the range of infrasound frequencies and using the elements and circuits designed for voltage polarization of the microphone.

### APPLICATION OF THE INVENTION

The invention can be applied in many branches in which condenser microphones can be used. The potential applications of the subject solution include, in particular, the branch of acoustic noise measurement equipment, especially for testing noise generated by wind turbines and wind turbine farms, moving cars and heavy vehicles. It will also find an application in wind turbine diagnostics.

### LIST OF REFERENCE NUMBERS

- 1: polarization resistor
- 2: separating capacitor
- 3: condenser microphone
- 4: operational amplifier
- 5: supply ground
- 6: polarization voltage source
- 7: first voltage source
- 8: first resistor
- 9: second resistor
- 10: third resistor
- 11: capacitor
- 12: second voltage source
- 13: third voltage source
- 14: fourth voltage source
- 15: fifth voltage source
- 16: polarization circuit the microphone and input of the operational amplifier

## Claims

1. A preamplifier for a condenser microphone operating in the infrasound frequency range, comprising an operational amplifier (4), a condenser microphone (3), which is formed by a capacitor and a polarization voltage source (6), **characterized in that** it has a polarization circuit (16) or a polarization resistor (1), wherein the polarization circuit (16) or the polarization resistor (1) is connected to the input of the operational amplifier (4) and to one end of the condenser microphone (3), wherein the second end of the condenser microphone (3) is connected to the polarization voltage source (6).

2. The preamplifier according to claim 1, **characterized in that** the polarization circuit (16) consists of a first resistor (8), a second resistor (9) and a third resistor (10), and a capacitor (11) compensating for the capacitance of the condenser microphone (3), wherein one end of the capacitor (11) is connected to the condenser microphone (3), to the inverting input of operational amplifier (4) and to the third resistor (10), whereas the other end thereof is connected to the output of the operational amplifier (4) and to the first resistor (8), wherein, between the first resistor (8) and the third (10), there is connected the second resistor (9), which in turn is connected to the second voltage source (12).

3. The preamplifier according to claim 1, **characterized in that** the polarization resistor (1) is connected to a voltage in the range of the input voltages of the operational amplifier (4) which is between the supply voltage of the operational amplifier (4) and the voltages of the fifth voltage source (15) and the fourth voltage source (14).

4. The preamplifier according to claims 1 or 2, **characterized in that** the second end of the polarization resistor (1) is connected to a supply ground (5) or the first voltage source (7).

5. The preamplifier according to claim 1, **characterized in that** the non-inverting input of the operational amplifier (4) is connected to the third voltage source (13) which is between the supply voltage of the operational amplifier (4) and the voltages of the fifth voltage source (15) and the fourth voltage source (14).
